## Europäisches Patentamt
## European Patent Office
## Office européen des brevets

(19)

(11) Veröffentlichungsnummer: **0 071 031**

**A2**

(12)

# EUROPÄISCHE PATENTANMELDUNG

(21) Anmeldenummer: **82105791.6**

(22) Anmeldetag: **29.06.82**

(51) Int. Cl.³: **H 01 L 23/48**
**H 01 L 23/56**

(30) Priorität: **31.07.81 DE 3130324**

(43) Veröffentlichungstag der Anmeldung: ﹍
**09.02.83 Patentblatt 83/6**

(84) Benannte Vertragsstaaten:
**BE CH FR GB IT LI NL SE**

(71) Anmelder: **GAO Gesellschaft für Automation und
Organisation mbH
Euckenstrasse 12
D-8000 München 70(DE)**

(72) Erfinder: **Obrecht, Werner
Rosenstrasse 7
D-8121 Wielenbach(DE)**

(72) Erfinder: **Haghiri-Tehrani, Yahya
Winzererstrasse 98
D-8000 München 40(DE)**

(72) Erfinder: **Hoppe, Joachim
Breisacherstrasse 1
D-8000 München 80(DE)**

(74) Vertreter: **DRes. Kador & Klunker
Corneliusstrasse 15
D-8000 München 5(DE)**

(54) **Trägerelement für einen IC-Baustein.**

(57) Ein Trägerelement für einen IC-Baustein zum Einbau in Datenträger, wobei der IC-Baustein über Leiterbahnen mit Kontaktflächen in Verbindung steht und die Kontaktflächen für eine berührende Kontaktabnahme ausgelegt sind.

Zum Schutz des Integrierten Bausteins gegen Zerstörung aufgrund statischer Ladungen sind Maßnahmen vorgesehen, die ggf. auftretende Ladungsanteile außerhalb des Schaltkreises ableiten. In einer Ausführungsform sind alle Anschlüsse des Schaltkreises untereinander niederohmig verbunden. Die Verbindung wird jeweils während der Betriebsphasen aufgehoben und anschließend wieder hergestellt. In einer weiteren Ausführungsform werden die Anschlüsse durch Funkenstrecken überbrückt. Diese Schutzmaßnahme hat den Vorteil, daß ein Entfernen und erneutes Aufbringen der Überbrückung entfällt.

Fig. 2

Croydon Printing Company Ltd.

## Trägerelement für einen IC-Baustein

Die Erfindung betrifft einen IC-Baustein zum Einbau in Ausweiskarten oder ähnliche Datenträger, wobei der auf oder im Trägerelement angeordnete IC-Baustein über Leiterbahnen mit Kontaktflächen in Verbindung steht.

Aus der DE-AS 29 20 012 ist eine Ausweiskarte der genannten Art mit eingebettetem IC-Baustein bekannt. Bei dieser Ausweiskarte ist der Baustein mit allen Zuleitungen und Kontakten auf einem separaten Trägerelement befestigt. Das Element wird derart in ein Fenster der Karte eingesetzt, daß sich die Kontaktflächen des Elements frei zugänglich an der Oberfläche der Karte befinden.

Für den Einbau in Ausweiskarten geeignete IC-Bausteine sollten bei hoher Komplexität und möglichst geringem Energieverbrauch kleine Abmaße aufweisen. Je kleiner die Bausteinfläche ist, um so geringer ist die Gefahr, daß der Schaltkreis während des Gebrauchs der Karte und den dabei unweigerlich auftretenden mechanischen Belastungen zerstört wird.

Komplexe integrierte Schaltkreise mit hoher Packungsdichte und auch geringem Energieverbrauch werden heute vorwiegend in der sog. MOS-Technologie gefertigt. Wie allgemein bekannt, sind MOS-Bausteine gegen statische Aufladungen sehr empfindlich. Es gibt daher für den Umgang mit diesen Bausteinen einschlägige Vorschriften, die zum Schutz der Bauelemente streng einzuhalten sind. Dies betrifft sowohl Herstellung, Lagerung als auch die Verarbeitung und den Betrieb des Bausteins. Wie leicht einzusehen ist, können diese Vorschriften nur bedingt eingehalten werden, wenn die Bausteine in Ausweiskarten eingebaut sind. In der oben zitierten Schrift sind für den IC-Baustein und die Kontakte keine besonderen Schutzmaßnahmen gegen etwaige Beschädi-

...

gungen durch statische Ladungen getroffen, die gerade im täglichen Gebrauch der Karte eine besondere Gefährdung darstellen.

Heute auf dem Markt erhältliche MOS-Bausteine höherer Komplexität sind zwar in der Regel mit Schutzeinrichtungen versehen, die in die Schaltungsstruktur mitintegriert werden. Trotz dieser Maßnahmen sind die Bausteine jedoch gegen statische Aufladungen zu schützen. Es sind weiterhin, wie von den Herstellern empfohlen, eine Reihe von Schutzmaßnahmen einzuhalten, die aber, wenn die Bausteine beispw. in Ausweiskarten eingebaut sind, aufgrund der besonderen Umstände nicht eingehalten werden können. Eine der Schutzmaßnahmen besteht beispw. darin, daß Personen oder Geräte, die mit dem Schaltkreis in Berührung kommen können, zu erden sind.

Die Aufgabe der Erfindung besteht deshalb darin, einen gegen statische Aufladungen weitgehend geschützten integrierten Baustein vorzuschlagen, der auch zum Einbau in Ausweiskarten geeignet ist.

Die Aufgabe wird erfindungsgemäß dadurch gelöst, daß alle Kopplungsmittel auf dem Trägerelement untereinander für statische Ladungen wirksame Überbrückungen aufweisen, die den Schaltkreis gefährdende Ladungsanteile ableiten.

Die Überbrückung kann eine niederohmige Verbindung zwischen den Kontakten bzw. zwischen den zu den Kontakten führenden Leiterbahnen sein. Die Verbindung wird jeweils während der Betriebsphasen aufgehoben und anschließend wieder hergestellt.

In einer beispielhaften Ausführungsform wird die Verbindung mit Hilfe eines alle Leiterbahnen kurzschließenden Kontaktstreifens hergestellt. Der Streifen ist Bestandteil des

...

den Schaltkreis und die Leiterbahnen aufnehmenden Trägerelements. Zum Betrieb des Schaltkreises wird der Streifen, wie weiter unten detailliert erläutert, beispw. mit mechanischen Mitteln soweit von den Leiterbahnen abgehoben, daß der Kurzschluß verschwindet.

In anderen Ausführungsformen der Erfindung wird die Überbrückung durch sog. Funkenstrecken realisiert. Diese Art der Überbrückung, die vor allem dann mit Erfolg eingesetzt werden kann, wenn ein Schaltkreis bereits mit internen integrierten Schutzeinrichtungen ausgerüstet ist, hat den Vorteil, daß der normale Betrieb des Schaltkreises nicht beeinträchtigt wird. Ein Entfernen und Wiederaufbringen der Überbrückung entfällt. Die Funkenstrecke ist so zu dimensionieren, daß statische Ladungen abgeleitet werden, bevor innere Strukturen des Schaltkreises von Durchschlägen zerstört werden. Wenn der Schaltkreis mit internen Schutzeinrichtungen ausgestattet ist, kann die Funkenstrecke so ausgelegt werden, daß sie erst bei höheren statischen Ladungen, die die Schutzeinrichtungen gefährden, anspricht. Dabei kann man von den wesentlichen, die Durchschlagsspannung einer Funkenstrecke beeinflußenden Parametern, wie Elektrodenabstand, Geometrie der Elektroden, Art des Dielektrikums etc. Gebrauch machen.

Nachfolgend werden Ausführungsbeispiele sowie weitere Einzelheiten der Erfindung anhand der Figuren näher beschrieben:

Darin zeigen:

Fig. 1    eine Ausweiskarte mit integriertem Schaltkreis,

Fig. 2    ein Trägerelement mit Kurzschlußstreifen,

Fig. 3    den Kurzschlußstreifen

Fig. 4    Trägerelement der Fig. 2 im Schnitt,

Fig. 5    Trägerelement der Fig. 2 im Schnitt,
          während der Betriebsphase,

...

Fig. 6     ein mit Funkenstrecken ausgerüstetes Trägerelement,

Fig. 7     elektrisches Analogon der in Fig. 6 gezeigten Anordnung,

Fig. 8     Trägerelement der Fig. 6 im Schnitt,

Fig. 9     ein weiteres Beispiel eines Trägerelements mit
           Funkenstrecken,

Fig. 10    das Trägerelement der Fig. 9 im Schnitt und

Fig. 11    das Trägerelement der Fig. 9 in einer rückwärtigen
           Ansicht.

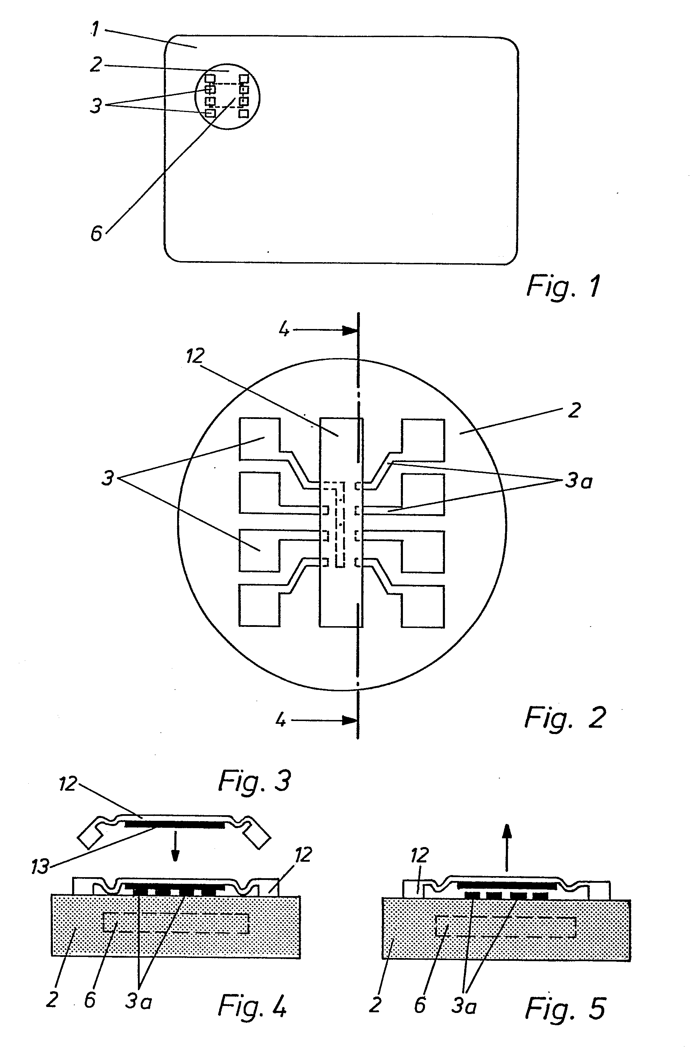

Die Fig. 1 zeigt eine Ausweiskarte 1 mit eingelagertem integrierten Schaltkreis.

Der IC-Baustein 6 ist mit den zum Betrieb des Bausteins notwendigen Kontakten 3 auf einem Trägerelement 2 angeordnet.
Das Trägerelement 2 wird in eine vorbereitete Aussparung
der Karte eingesetzt und mit dem Kartenlaminat verbunden.

Die Gefahr einer Zerstörung des Schaltkreises besteht dann,
wenn einer der Kontakte mit einer statischen Ladung in Berührung kommt, die durch den Schaltkreis über einen zweiten
Kontakt abfließen kann, der beispw. gerade mit einem  Erdpotential führenden Gegenstand in Verbindung steht. Welche
Ladung ausreichend ist, um den Schaltkreis zu zerstören
oder ihn in seinen elektrischen Werten zu verändern, ist
von vielen Faktoren, unter anderem auch vom Schaltkreistyp
abhängig.

Grundsätzlich kann davon ausgegangen werden, daß die in Ausweiskarten eingebauten Schaltkreise durch die die Karten
benutzenden Personen mit statischen Ladungen in der Größenordnung von 10 kV und mehr in Berührung kommen können.
Der Schaltkreis würde bei entsprechender Entladung also unweigerlich zerstört, auch wenn es sich um einen mit internen Schutzeinrichtungen (Löschdioden) ausgerüsteten Schaltkreis handelt, der statische Ladungen in der Größenordnung
von etwa 1 bis 2 kV, ohne Schaden zu nehmen, kompensieren kann.

Nachfolgend wird anhand von Ausführungsbeispielen beschrieben, wie beispw. in Ausweiskarten eingebaute Schaltkreise gegen die im täglichen Gebrauch der Karte möglicherweise auftretenden statischen Ladungen weitgehend geschützt werden
können.

Die Fig. 2 bis 5 zeigen eine Ausführungsform der Erfindung,
bei der alle Anschlüsse des Bausteins kurzgeschlossen werden, solange Ausweiskarte bzw. Schaltkreis nicht in Betrieb sind. Während der Betriebsphasen wird der Kurzschluß
aufgehoben. Bei dem beispw. in der Fig. 2 gezeigten Trägerelement 2 mit den Kontaktflächen 3 (siehe auch Schnittdarstellung in Fig. 4) werden die zum Baustein führenden Leiterbahnenden 3a durch einen Kontaktstreifen 12 kurzgeschlossen.
Der Kontaktstreifen 12 (Fig. 3) ist mit leitendem Material 13
beschichtet und wird bei seiner Herstellung derart mechanisch
vorgespannt, daß er, befestigt auf dem Trägerelement, mit
seiner leitenden Schicht die Leiterbahnen kurzschließt.

Zum Betrieb des Schaltkreises wird der Kontaktstreifen von den
Leiterbahnen abgehoben, wie in der Fig. 5 gezeigt. Dies kann
beispw. mit einem in den Kontaktkopf integrierten Saugrohr
(in den Fig. nicht gezeigt) durchgeführt werden. Aufgrund der

...

Vorspannung des Streifens wird der Kurzschluß nach der Betriebsphase automatisch wieder hergestellt.

Der Kurzschluß zwischen den Anschlußleitern des Bausteins kann auch dadurch hergestellt werden, daß alle Kontakte mit Hilfe einer leitenden Schicht überbrückt werden. Die Schicht wird vor der Kontaktierung im jeweiligen Prüfgerät von einer dafür vorgesehenen Vorrichtung entfernt und vor Ausgabe der Karte wieder aufgebracht.

Diese Schicht kann eine sehr dünne leitende Folie sein, die aufgrund von Adhäsionskräften auf der Kontaktoberfläche "klebt". Es ist ebenso möglich eine selbstklebende leitende Folie zu verwenden, die auf die Ausweiskarten-Oberfläche zumindest im Bereich der Kontaktflächen geklebt wird. Zum Entfernen und Aufbringen der Schichten bieten sich eine Reihe von Verfahren an, die, nicht Gegenstand dieser Erfindung, hier nicht näher ausgeführt werden müssen.

Schließlich sei noch erwähnt, daß der Kurzschluß auch durch einen leitenden Lack erzielt werden kann. Der Lack wird im Automaten vor der Betriebsphase mit Hilfe eines geeigneten Lösungsmittels entfernt und vor Ausgabe der Karte an den Benutzer wieder aufgebracht.

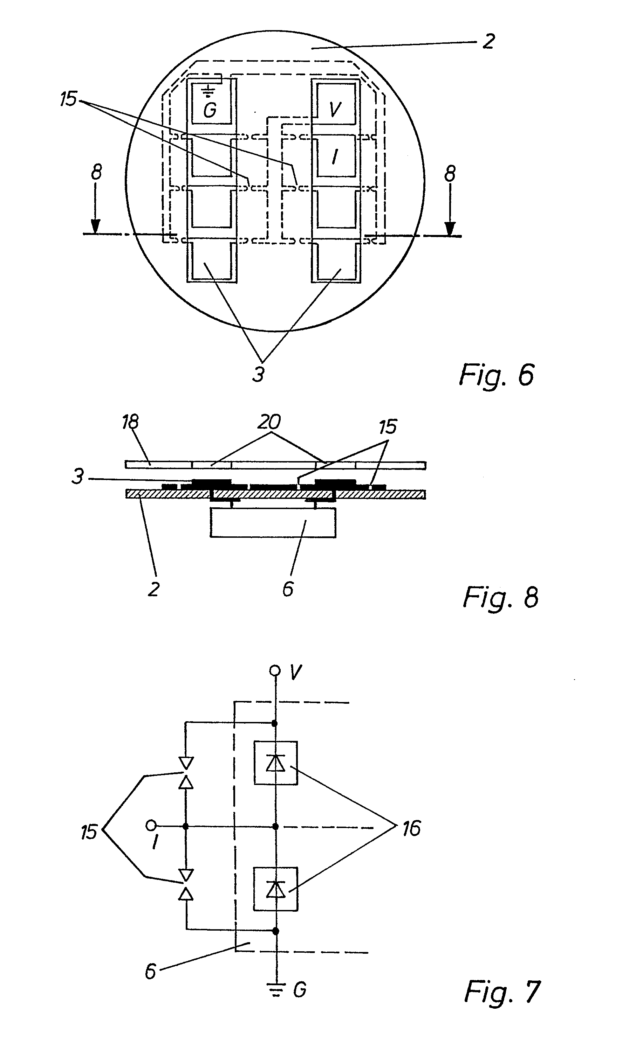

Neben der Möglichkeit, die Anschlußleiter des IC-Bausteins in den Zeiten potentieller Gefährdung kurzzuschließen, sind, wie erwähnt, weitere Ausführungsformen der Erfindung zum Schutz des Bausteins durch eine als Funkenstrecke wirkende Überbrückung gekennzeichnet. Dazu zeigen die Fig. 6, 7 und 8 ein Ausführungsbeispiel. Bei dieser Art der Überbrückung ist es günstig, wenn der Schaltkreis bereits intern mit Schutzeinrichtungen (Löschdioden) ausgerüstet ist. Bei der Dimen-

...

sionierung der Funkenstrecke kann dann nämlich von einer höheren Ansprechschwelle ausgegangen werden, was deren Realisierung erleichtert.

Die Schutzeinrichtungen, z. B. zwischen Schaltkreiseingang und Masse- bzw. Versorgungsanschluß geschaltete Netzwerke, sollten dann diejenigen Ladungspotentiale schadlos kompensieren, bei denen die Funkenstrecken noch nicht ansprechen.

In dem gezeigten Ausführungsbeispiel wird davon ausgegangen, daß die mit "G" bezeichnete Kontaktfläche als Masseanschluß und die mit "V" bezeichnete Kontaktfläche als Anschluß für die Spannungsversorgung verwendet wird. Die mit "I" bezeichnete Kontaktfläche sei mit einer Eingangsleitung des integrierten Schaltkreises verbunden. Wie auch in dem stark schematisierten elektrischen Blockschaltbild in der Fig. 7 gezeigt, sind sowohl der Masseanschluß "G" als auch der Anschluß "V" für die Spannungsversorgung über je eine Funkenstrecke 15 mit der Eingangsleitung "I" des integrierten Schaltkreises 6 verbunden. Die Funkenstrecken liegen parallel zu den innerhalb des Schaltkreises vorgesehenen Schutznetzwerken 16, die hier durch Schutzdioden symbolisiert sind.

Die Durchschlagfestigkeit der Funkenstrecken 15, d. h. diejenige Feldstärke, bei der das Isolationsvermögen zwischen den Elektroden der Strecke verschwindet, gemessen in kV/cm, muß kleiner sein, als die Durchschlagfestigkeit der Schutznetzwerke 16 innerhalb des Schaltkreises 6.

Durch einen entsprechend geringen Abstand zwischen Elektroden mit möglichst geringem Krümmungsradius und einem Dielektrikum mit geringer Durchschlagfestigkeit wird erreicht, daß die Funkenstrecken durchschlagen und die statische Ladung abgeleitet wird, bevor die Schutznetzwerke sowie die nachgeschalteten Schaltkreiseinheiten zerstört werden. Ein Einbrennen der Funkenstrecken kann durch entsprechende Auswahl der Ma-

...

- 8 -

teralien leicht vermieden werden, zumal die Leistungen der hier infrage kommenden statischen Ladungen gering sind.

In dem gezeigten Ausführungsbeispiel sind alle Ein- bzw. Ausgänge des Schaltkreises untereinander und mit den Bezugspotentialen, Masse- und Versorgungsanschluß, über Funkenstrecken miteinander verbunden. Die gewählte Anordnung der Funkenstrecken ist mehr oder weniger willkürlich. Anzahl, Anordnung und Dimensionierung der Funkenstrecken sind vom jeweils zu schützenden Schaltungstyp abhängig und entsprechend zu wählen.

Wie in Fig. 6 und auch in der Schnittdarstellung der Fig. 8 gezeigt, kann das Trägerelement zum Schutz der Funkenstrecken gegen Beschädigung und Verschmutzung mit einer dünnen Folie 18 abgedeckt werden, die im Bereich der Kontaktflächen 3 mit Aussparungen 20 versehen ist.

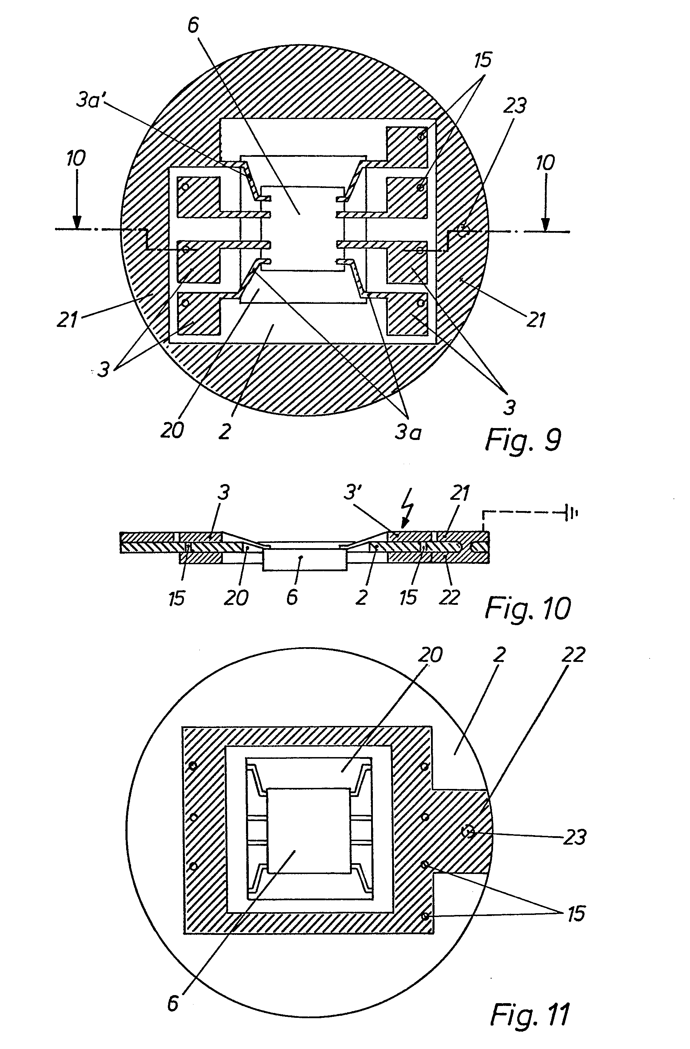

Die Fig. 9, 10 und 11 zeigen eine weitere Ausführungsform einer Funkenstrecke zum Schutz integrierter Schaltkreise gegen statische Ladungen. Die Fig. 9 zeigt die Vorderseite, die Fig. 10 einen Schnitt entlang der Linien 10-10 und die Fig. 11 die Rückseite des Trägerelements 2.

Der in einem Fenster 20 des Trägerelements 2 angeordnete IC-Baustein 6 ist über Leiterbahnen 3a mit den Kontaktflächen 3 verbunden. Die Leiterbahn 3a', die die Verbindung zum Masseanschluß des Bausteins herstellt, ist außerdem mit einem ringförmigen, alle Kontakte einschließenden, leitenden Belag 21 verbunden, der die gesamte neben den Kontakten verbleibende Fläche abdeckt. Der Abstand zwi-

...

schen dem Belag 21 und den einzelnen Kontaktflächen kann relativ groß sein, so daß beispw. durch Verschmutzung verursachte Überbrückungen nicht zu befürchten sind. Auf der Rückseite des Trägerelements ist eine ebenfalls ringförmige leitende Elektrode 22 vorgesehen, der im wesentlichen mit der durch die Kontakte 3 eingenommenen Fläche kongruent ist. Wie in der Fig. 10 zu erkennen ist, sind Belag 21 und Elektrode 22 über eine durchkontaktierte Leitung 23 galvanisch miteinander verbunden. Zwischen je einer Kontaktfläche 3 und der rückseitigen, leitenden Elektrode 22 ist eine Funkenstrecke 15 in Form einer Durchbohrung vorgesehen. Der Elektrodenabstand der Funkenstrecke wird durch die Dicke des Trägerelementmaterials bestimmt. Damit kann ein wesentlicher Parameter in der Dimensionierung der Funkenstrecke durch entsprechende Wahl der Foliendicke auf einfache Weise eingestellt werden.

Wie schon erwähnt, besteht die Gefahr einer Zerstörung des Schaltkreises vor allem dann, wenn beispw. eine der Kontaktflächen eine statische Ladung aufnimmt, die über eine andere Kontaktfläche, die beispw. mit Erdpotential in Verbindung steht, durch den Schaltkreis abfließt.

Ergibt sich diese Situation bei dem Schaltkreis bzw. Trägerelement gemäß der Erfindung, dann sorgen die Funkenstrecken 15 dafür, daß die Ladung nicht durch den Schaltkreis sondern oberflächlich über die leitenden Beläge des Trägerelements abfließt.

Wie in der Fig. 10 durch Symbole angedeutet, fließt eine auf die Kontaktfläche 3' gelangende Ladung entsprechender Höhe bei einem Durchschlag der Funkenstrecke 15 über diese, Elektrode 22 über die Durchkontaktierung 23 und den Belag 21 zur Masse hin ab.

...

Der besseren Übersicht wegen sind die tatsächlichen Verhältnisse in der Schnittdarstellung in der Fig. 10 nicht maßstabgetreu wiedergegeben. Der Abstand zwischen der Kontaktfläche 3' und dem Belag 21 ist in Wirklichkeit wesentlich größer, als der durch die Folie 2 vorgegebene Abstand zwischen der Kontaktfläche 3' und der Elektrode 22, der gleich dem Elektrodenabstand der Funkenstrecke 15 ist.

In dem gezeigten Ausführungsbeispiel sind die Kontaktflächen 3 der integrierten Schaltung über je eine Funkenstrecke mit dem Masseanschluß der Schaltung, d.h. mit dem Kontaktring bzw. Belag 21 verbunden. Die Kontaktflächen untereinander sind demnach durch zwei in Serie geschaltete Funkenstrecken überbrückt. Das heißt, daß es zwischen zwei Kontaktflächen erst bei höherer Potentialdifferenz zum Ausgleich einer statischen Ladung kommt. Es ist selbstverständlich möglich, auch Funkenstrecken zwischen den Kontakten selbst vorzusehen. Das dürfte jedoch, wenn ein großflächiger Belag 21 vorhanden ist, in der Regel nicht notwendig sein, da die Wahrscheinlichkeit sehr hoch ist, daß dieser alle Kontakte einschließende Belag an der Ableitung einer statischen Ladung beteiligt ist.

Dem Fachmann ist klar, daß die oben dargestellten Ausführungsformen nur beispielhaft für die Vielzahl der Möglichkeiten stehen und daß die jeweils zu verwendende Form vom Einzelfall abhängig angepaßt werden muß.

...

G A O
Gesellschaft für Automation
und Organisation mbH
Euckenstr. 12

8000  M ü n c h e n  70

---

Trägerelement für einen IC-Baustein

---

P a t e n t a n s p r ü c h e

1. Trägerelement für einen IC-Baustein zum Einbau in Ausweiskarten oder ähnliche Datenträger, wobei der auf oder im Trägerelement angeordnete IC-Baustein über Leiterbahnen mit Kontaktflächen in Verbindung steht, dadurch  g e k e n n z e i c h n e t, daß die Kontaktflächen (3) oder Leiterbahnen (3a) außerhalb des IC-Bausteins (6) untereinander für statische Ladungen wirksame Überbrückungen aufweisen.

...

2. Trägerelement nach Anspruch 1, dadurch g e - k e n n z e i c h n e t, daß die Kontaktflächen (3) oder Leiterbahnen (3a) niederohmig miteinander verbunden sind und diese Verbindung während der Betriebsphase mit dem IC-Baustein (6) aufgehoben wird.

3. Trägerelement nach Anspruch 2, dadurch g e - k e n n z e i c h n e t, daß die Überbrückung durch eine auf den Leiterbahnen (3a) bzw. Kontaktflächen (3) aufliegende Verbindungsbrücke (12) erfolgt, die während der Betriebsphase abgehoben wird.

4. Trägerelement nach Anspruch 2, dadurch g e - k e n n z e i c h n e t, daß die Überbrückung durch eine auf den Leiterbahnen (3a) bzw. Kontaktflächen (3) aufliegende, leitende Folie erfolgt, die während der Betriebsphase abgehoben wird.

5. Trägerelement nach Anspruch 2, dadurch g e - k e n n z e i c h n e t, daß die Überbrückung durch einen auf die Leiterbahnen (3a) bzw. Kontaktflächen (3) aufgebrachten, leitenden Lack erfolgt, der während der Betriebsphase entfernt wird.

6. Trägerelement nach Anspruch 1, dadurch g e - k e n n z e i c h n e t, daß die Kontaktflächen (3) bzw. Leiterbahnen (3a) untereinander über für Überspannung wirksame Funkenstrecken (15) verbunden sind.

7. Trägerelement nach Anspruch 6, dadurch g e - k e n n z e i c h n e t, daß eine der Elektroden (22) der Funkenstrecke, deren Fläche etwa dem Gesamtkontaktbereich entspricht, unterhalb der Folie (2) angeordnet ist, auf welcher die Kontaktflächen (3) liegen

...

und daß die Folie (2) im Bereich der Kontaktflächen (3) jeweils eine Durchbohrung (15) aufweist.

8. Trägerelement nach Anspruch 7, dadurch  g e -
k e n n z e i c h n e t, daß die Kontaktflächen (3)
von einem leitenden Belag (21) ringförmig umgeben
sind, der mit der Elektrode (22) durch die Folie
(2) hindurch elektrisch leitend verbunden ist.

...

Fig. 1

Fig. 2

Fig. 3

Fig. 4

Fig. 5

Fig. 6

Fig. 8

Fig. 7

Fig. 9

Fig. 10

Fig. 11